# EUROPEAN PATENT APPLICATION

(11) **EP 4 826 997 A1**
(43) Date of publication of application: **21.10.2026**
(21) Application number: 26172155.9
(22) Date of filing: 14.04.2026
(51) Int. Cl.: H03G 9/02, H03F 3/181, H03G 3/30

(54) **AUDIO SYSTEM AND METHOD FOR PROVIDING SATURATION ON AUDIO OUTPUT**

(30) Priority: 14.04.2025 US 202563788426 P; 25.03.2026 US 202619577850
(71) Applicant: Harman Becker Automotive Systems, Inc., Novi, MI 48377 (US)
(72) Inventor: DAFTUAR, Rishi, Ypsilanti, MI 48197 (US); PORTER, James McCallister, Highland Park, MI 48203 (US); HUMPHREY, Stephen Michael, Royal Oak, MI 48073 (US)
(74) Representative: Rummler, Felix

(57) **Abstract**

An audio system includes an amplifier including at least one controller and being programmed to receive an audio input signal; apply saturation to at least the audio input signal by introducing non-linear distortion to provide an audio output signal; and transmit an audio output signal to one or more loudspeakers to playback the audio out of a first loudspeaker of the one or more loudspeakers.

## Description

### CROSS-REFERENCE TO RELATED APPLICATION

This application claims the benefit of U.S. provisional application Serial No. 63/788,426 filed April 14, 2025, the disclosure of which is hereby incorporated in its entirety by reference herein.

### TECHNICAL FIELD

Aspects disclosed herein generally relate to an audio system and method for providing saturation on an audio output. These aspects and others will be discussed in more detail below.

### BACKGROUND

An audio amplifier (or power amp) generally amplifies low power audio input signals as received from an audio source. In this case, the audio amplifier increases the output level of the power audio input signal to a level that is high enough for driving one or more loudspeakers in a listening environment. Generally, the audio amplifier may be a final electronic device that is present in an audio playback chain before the audio output of the amplifier is transmitted to the loudspeakers. Preceding stages to the audio amplifier may include an equalizer and/or mixers that mix various inputs.

### SUMMARY

In at least one embodiment, an audio system is provided. The audio system includes an amplifier including at least one controller and being programmed to receive an audio input signal; apply saturation to at least the audio input signal by introducing non-linear distortion to provide an audio output signal; and transmit an audio output signal to one or more loudspeakers to playback the audio out of a first loudspeaker of the one or more loudspeakers..

In at least another embodiment, a method is provided. The method includes receiving an audio input signal; applying saturation to at least the audio input signal to generate a saturated signal and provide an audio output signal; and playing back the audio output signal via one or more loudspeakers.

In at least another embodiment, a computer-program product embodied in a non-transitory computer readable medium that is stored in memory and that is programmed and executable by at least one controller in an audio system is provided. The computer-program product includes instructions to receive an audio input signal; apply saturation to at least the audio input signal to generate a saturated signal and provide an intermediate signal; and mix the intermediate signal with the audio input signal to generate an audio output signal.

### BRIEF DESCRIPTION OF THE DRAWINGS

The embodiments of the present disclosure are pointed out with particularity in the appended claims. However, other features of the various embodiments will become more apparent and will be best understood by referring to the following detailed description in conjunction with the accompany drawings in which:
Figure 1 generally depicts an audio system for providing saturation on an audio output signal in accordance with one embodiment; and
Figure 2 generally depicts an amplifier of the audio system of Figure 1 in accordance with one embodiment.
Figure 3 generally depicts a flow diagram for an audio processing method in accordance with one embodiment.

### DETAILED DESCRIPTION

As required, detailed embodiments of the present invention are disclosed herein; however, it is to be understood that the disclosed embodiments are merely exemplary of the invention that may be embodied in various and alternative forms. The figures are not necessarily to scale; some features may be exaggerated or minimized to show details of particular components. Therefore, specific structural and functional details disclosed herein are not to be interpreted as limiting, but merely as a representative basis for teaching one skilled in the art to variously employ the present invention.

Aspects disclosed herein generally provide, among other things, an amplifier including an audio signal processor that adds an aural excitation to an audio input signal. Aural excitation generally corresponds to the process of adding saturation and dynamics enhancement based on an envelope of the audio input signal. The amplifier (e.g., or exciter) utilizes a full-wave (or half-wave) rectifier for the purposes of tracking the envelope of the audio input signal. In one example, the audio input signal may be saturated (operates non-linearly) for the purpose of creating distortion and compression. A saturator may be included that is part of the amplifier.

The audio signal processor, in effect, may function as a distorted envelope follower that tracks the changes in dynamics related to the audio input signal. This is mixed in with the original audio signal (or audio input signal), thus providing some level of distortion and dynamics that provide an enhancement and is pleasant leading to an increase in the listening experience. Additionally, the audio input signal and sound characteristic may change drastically based on an input gain (e.g., volume). This generally entails that the audio signal processor impacts the sound dynamically.

One intended use of the disclosed system and/or method may be executed by an automotive amplifier microprocessor that is positioned outside of a main digital signal processor (DSP) that used in sound tuning. However, it is recognized that the disclosed system/method may be used in other areas of the sound tuning/audio calibration. The disclosed embodiment may provide:
1. A signal flow that employed for the audio signal processor (or amplifier) that utilizes a full-wave rectifier and a cubic function to provide saturation distortion; and
2. A sonic signature for an automotive amplifier. Automotive amplifiers are traditionally implemented to require clean input and output characteristics. The disclosed embodiments add distortion/color to audio input signal that is processed by an automotive amplifier.

Generally, the disclosed embodiments may add a sonic characteristic to an amplifier that is not found in automotive amplifier solutions and also add dynamic characteristics that are beneficial to audio sound quality. Such benefits may include:
1. Adding a sonic signature to an automotive amplifier, this of course, may be relevant for branded audio.
2. Distortions that are often found in audio signals and have "pleasing" characteristics (e.g., a tube amplifier). Thus, bringing this type of sound to the automotive field where it would otherwise be expensive and not practical to include such circuitry.
3. Adding clarity, punch, and power to the audio input signal while providing an audio output signal by any number of loudspeakers thereby augmenting the original audio input signal by adding dynamics.
4. Improving high volume amplifier performance by providing audio saturation instead of distortion/clipping.

Current implementations try to maintain clean audio paths and reach non-linear behavior through component overload. However, additionally, sonic flavor may be traditionally done using static processors or processors that operate in a fixed way (e.g., equalizers, compressors, limiters).

In general, the disclosed amplifier may provide dynamic equalization and include an audio processor that may be a non-linear processor. For one desired application, it is possible to provide an amplifier (e.g., automotive amplifier) that enhances transient response, clarity, harmonics, and perceived loudness. Similarly, the disclosed amplifier may increase the above noted enhancements which provides more volume of the gain that is provided to the processor may be increased. Therefore, the disclosed amplifier may be running in real-time/near real-time and responds dynamically as the volume (the gain being provided on the audio input signal and to the amplifier) may be increased or decreased.

The disclosed amplifier may be implemented with analog circuity or other embodiments a digital signal processor (DSP) is positioned within a microcontroller (or audio processor) positioned directly before a power stage of the amplifier. Thus, positioning the audio DSP processing before (or upstream) a power ICs/output stage of an amplifier may be advantageous to provide the aural excitation. One implementation with respect to audio amplification, especially in automotive, is to transparently amplify the original sound signal.

This disclosed amplifier purposely adds in distortion/non-linear behavior for the purpose of improving sound quality. The audio signal processor of the amplifier may be positioned at a predetermined location within the amplifier. In one example, the location of the audio signal processor may be positioned directly before a power IC amplification circuit and operates on a single or multiple channels with identical settings for all amplifier channels. In general, one use case of the saturator/exciter is in a music creation process rather than on sound reproduction.

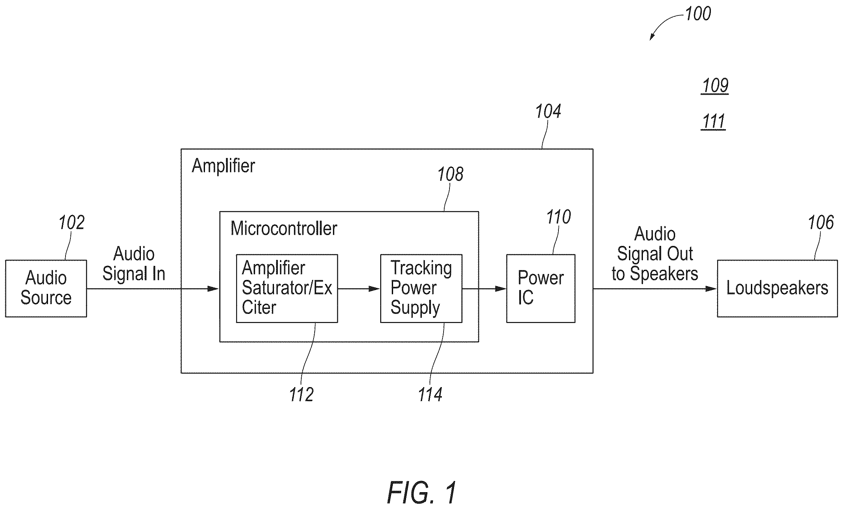

Figure 1 generally depicts an audio system 100 for providing saturation for an audio output signal in accordance with one embodiment. The system 100 includes an audio source 102, an amplifier 104, and one or more loudspeakers 106 (the loudspeaker 106 hereafter). In general, the audio source 102 provides an audio input signal to the amplifier 104. The amplifier 104 amplifies the audio input signal to provide an audio output signal that is provided to the loudspeaker 106. The loudspeaker 106 plays back the audio output signal in a listening environment 109 (e.g., cabin of a vehicle 111).

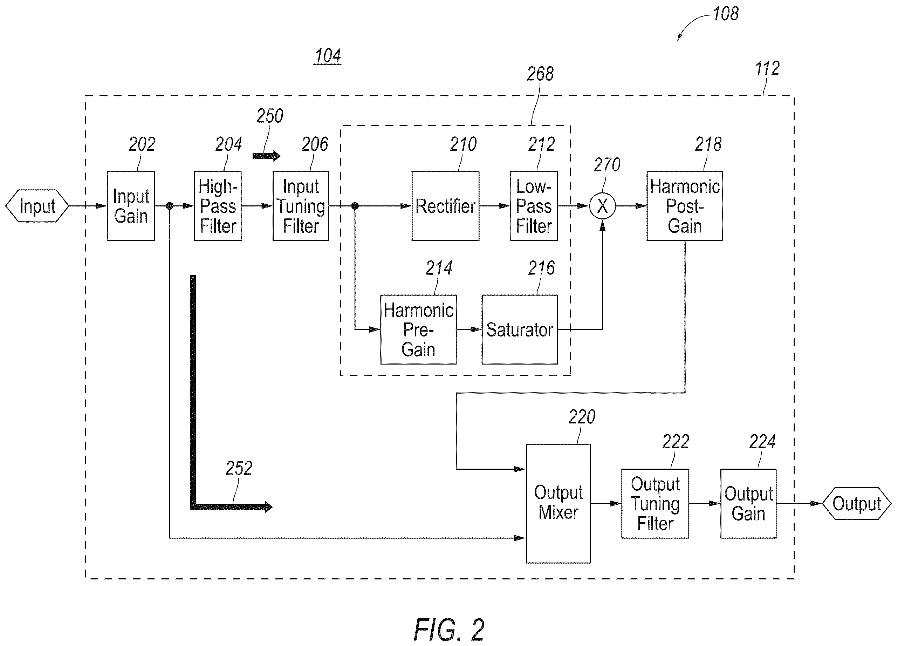

The amplifier 104 includes at least one controller ("the controller") (e.g., microcontroller or audio input processor) 108 and a power integrated circuit (IC) 110. The power IC 110 serves as an output amplification stage and provides power amplification operation(s) for the amplifier 104. It is recognized that the power IC 110 may be a discrete output circuit for automotive or other applications such as home audio. The controller 108 includes a first circuit 112 and a tracking power supply 114. In general, the tracking power supply 114 allows for the amplifier 104 to run more efficiently by supplying the desired amount of voltage to reproduce the audio signal. This may be considered a requirement in automotive amplifiers as thermal and power draw efficiency may be essential factors. While Figure 1 generally illustrates that the first circuit 112 is positioned directly before the tracking power supply 114, it is recognized that the first circuit 112 may be positioned within the power IC 110. In general, the first circuit 112 (e.g., exciter or saturation circuit) may add harmonics into the audio input signal provided by the audio source 102 to provide the effect of applying saturation based on the dynamics of the audio input signal. This will be discussed in more detail in connection with Figure 2.

Figure 2 generally depicts a detailed block diagram of the amplifier 104 of the audio system 100 of Figure 1 in accordance with one embodiment. In particular, Figure 2 generally illustrates various aspects related to the first circuit 112. The first circuit 112 includes an input gain block 202, a first filter (e.g., high pass filter) 204, a second filter (e.g., input tuning filter) 206, a rectifier 210, a third filter (e.g., low pass filter) 212, a harmonic pre-gain block 214, a saturator circuit 216, a harmonic post-gain circuit 218, an output mixer 220, a fifth filter (e.g., output tuning filter) 222, and an output gain 224. It is recognized that the input tuning filter 206 and/or the output tuning filter 222 may include any number of filters.

The operation of the amplifier 104 is set forth as follows. The input gain block 202 generally adjusts an input level of the audio input signal as received from the audio source 102. The amplifier 104 includes a first path 250 (e.g., effect or wet path) in which the output of the first gain block 250 traverses through the first filter 204, the second filter 206, the rectifier 210, the third filter 212, the harmonic pre-gain block 214, the saturator circuit 216, and a multiplier circuit 270. The amplifier 104 includes a second path 252 (e.g., dry path) in which the output of the input gain block 202 is transmitted directly to the output mixer 220. On the wet path 250, the first filter 204 high pass filters the output of the input gain block 202 such that the effects employed on the wet path 250 operate only frequencies that are above a predetermined cutoff frequency. In one example, the first filter 204 may be a tunable high pass filter. The second block 206 receives the high pass filtered output of the first filter 204. The second block 206 (or input tuning filter 206) may include a block of biquads that may be tuned on the wet path 250. For example, the input tuning filter 206 may include a bank of tunable biquads so that spectral qualities maybe adjusted, only on the wet path 250.

A harmonic exciter 268 includes the rectifier 210, the third filter 212, the harmonic pre-gain block 214, and the saturator circuit 216. The rectifier 210 converts the output of the input tuning filter 206 that generally includes positive and negative values to a signal with only positive values. For example, the rectifier 210 converts the output signal (or audio signal) that generally includes both positive and negative values into a signal with only positive values. The rectifier 210 functions as an absolute value function.

The third filter 212 (or low pass filter) then smooths out this signal. As noted, the third filter 212 may be a low pass filter that includes a low cutoff frequency that is used to smooth out the output provided by the rectifier 210. In general, the rectifier 210 and the third filter 212 form an envelope follower which tracks the amplitude of the output of the input tuning filter 206. Also on the wet path 250, the input tuning filter 206 provides an output to the harmonic pre-gain block 214 and to the saturator block 216. In general, the harmonic pre-gain block 214 controls in input level of the output provided to the saturator block 216.

A higher gain provided by the harmonic pre-gain block 214 may result in more saturation. The saturator block 216 may be a nonlinear function that adds harmonics to the audio signal provided by the harmonic pre-gain block 214. The harmonic pre-gain block 214 controls a level of the added harmonics by "driving" the signal into the nonlinear function of the saturator block 216. The multiplier circuit 270 multiples the output from the third filter 212 and the output from the saturator block 216. Such multiplication has the effect of applying saturation based on dynamics of the audio input signal therefore the output of the saturator block 216 serves as a transient enhancer. In general, the inclusion of the saturator block 216 has the effect of applying saturation only when the signal is loud. Therefore, the saturator block 216 serves as, for example, a sort of transient enhancer. The output mixer 220 mixes the output of the wet path 250 and the clean path 252. In general, the output mixer 220 mixes the output of the wet path 250 and the clean path 252 to recombine such outputs. The output mixer 220 is tunable and provides a tuned wet/dry mix. The fifth filter (e.g., output tuning filter) 222 includes another set of tunable biquads. The output gain block 224 adjusts a gain of the audio output signal as output by the fifth filter 222.

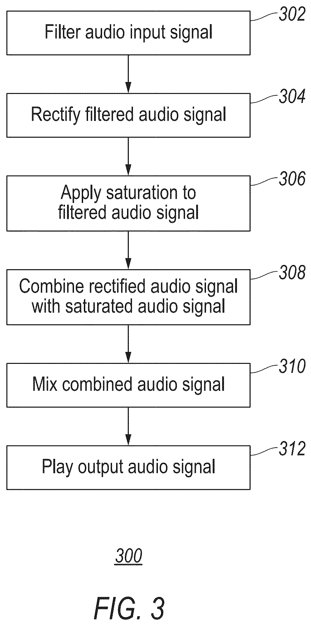

Figure 3 generally depicts a flow diagram for an audio processing process 300 in accordance with one embodiment. With continuing reference to Figures 1 and 2, the process 300 may be implemented via various components of the audio system 100. The following description will be made with reference to the amplifier 104 for simplicity.

In response to receiving an audio input signal, at operation 302, the amplifier 104 performs filtering operations to the audio input signal to generate a filtered signal. The filtering operation may be performed via one or more filters. For instance, the filtering operation 302 may include a high-pass filtering operation via the high-pass filter 204 such that only the signal with frequencies that are above a predetermined threshold frequency is processed. Additionally or alternatively, the filtering operation 302 may include an input tuning filtering operation via the input tuning filter 206 including a bank of tunable biquads to adjust the spectral qualities of the audio input signal and output the filtered audio signal.

At operation 304, the filter 104 rectifies the filtered audio signal via the rectifier 210 to generate a rectified signal. For instance, the rectifier may convert the filtered audio signal that generally includes both positive and negative values into a signal with only positive values. Additionally, the signal output from the rectifier may be further smoothed out via the low-pass filter 212.

In parallel with operation 304, the amplifier 104 applies saturation to the filter audio signal via the saturator 216 to generate a saturated signal. As discussed above, the saturator may serve as a transient enhancer and may apply the saturation only to loud audio signals. Additionally, the filtered signal may be further pre-processed via the harmonic pre-gain block 214 that controls the level of the added harmonics by "driving" the signal into the nonlinear function of the saturator block 216.

At operation 308, the amplifier 104 combines the rectified audio signal with the saturated audio signal via the multiplier 270 to generate a combined/intermediate audio signal.

At operation 310, the amplifier 104 mixes the combined audio signal via the original input audio signal via the output mixer 220 to generate the output audio signal. The mixer 220 may be adjustable depending on the user's need such that the ratio of the original input audio signal and the processed combined audio signal may be at a desirable level.

At operation 312, one or more loudspeakers 106 output audio sounds using the output audio signal.

It recognized that the controllers as disclosed herein may include various microprocessors, integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, such controllers as disclosed utilizes one or more microprocessors to execute a computer-program that is embodied in a non-transitory computer readable medium that is programmed to perform any number of the functions as disclosed. Further, the controller(s) as provided herein includes a housing and the various number of microprocessors, integrated circuits, and memory devices ((e.g., FLASH, random access memory (RAM), read only memory (ROM), electrically programmable read only memory (EPROM), electrically erasable programmable read only memory (EEPROM)) positioned within the housing. The controller(s) as disclosed also include hardware-based inputs and outputs for receiving and transmitting data, respectively from and to other hardware-based devices as discussed herein.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### Additional Examples

Example 1: An audio system comprising: an amplifier including at least one controller and being programmed to: receive an audio input signal; apply saturation to at least the audio input signal by introducing non-linear distortion to provide an audio output signal; and transmit an audio output signal to one or more loudspeakers to playback the audio out of a first loudspeaker of the one or more loudspeakers.

Example 2: The system of example 1, wherein the at least one controller is further programmed to add harmonics to the audio input signal prior to applying saturation.

Example 3: The system of example 1 or 2, wherein the at least one controller is further programmed to rectify the audio input signal prior to applying saturation to the audio input signal.

Example 4: The system of example 3 wherein the at least one controller includes a first filter that is programmed to filter out frequencies on the audio input signal that are above a first predetermined frequency after rectifying the audio input signal to provide an intermediate audio signal.

Example 5: The system of example 4, wherein the intermediate audio signal is indicative of an envelope follower which tracks an amplitude of the audio input signal.

Example 6: The system of example 5, wherein the at one controller is further programmed to multiply the intermediate audio signal by a signal that includes the saturation to provide the audio output signal.

Example 7: The system of any of examples 1 to 6, wherein the amplifier defines a first path in which the audio input signal traverses at least one of a first filter, a second filter, a rectifier, a third filter, a harmonic pre-gain block, and a saturation circuit to provide a saturated audio signal.

Example 8: The system of example 7, wherein the amplifier defines a second path in which the audio input signal is mixed with the saturated audio signal from the first path to provide the audio output signal prior to the audio output signal being played out by the one or more loudspeakers.

Example 9: The system of any of examples 1 to 8, wherein the amplifier is positioned in a vehicle.

Example 10: A method comprising: receiving an audio input signal; applying saturation to at least the audio input signal to generate a saturated signal and provide an audio output signal; and playing back the audio output signal via one or more loudspeakers.

Example 11: The method of example 10, further comprising: adding harmonics to the audio input signal prior to applying saturation.

Example 12: The method of example 10 or 11, further comprising: rectifying the audio input signal to generate a rectified signal; combining the rectified signal with saturated signal to generate a combined signal; and mixing the combined signal with the audio input signal to generate the audio output signal.

Example 13. The method of example 12 further comprising: filtering out frequencies above a first predetermined frequency after rectification to provide rectified signal, wherein rectified signal is indicative of an envelope follower which tracks an amplitude of the audio input signal. Example 14. A computer-program product embodied in a non-transitory computer readable medium that is stored in memory and that is programmed and executable by at least one controller in an audio system, the computer-program product comprising instructions to: receive an audio input signal; apply saturation to at least the audio input signal to generate a saturated signal and provide an intermediate signal; and mix the intermediate signal with the audio input signal to generate an audio output signal.

Example 15. The computer-program product embodied in the non-transitory computer readable medium of example 14, the computer-program product comprising instructions to: rectify the audio input signal to generate a rectified signal; combine the rectified signal with the saturated signal to generate the intermediate signal.

Example 16. The computer-program product embodied in the non-transitory computer readable medium of example 14 or 15, the computer-program product comprising instructions to: add harmonics to the audio input signal prior to applying saturation.

Example 17. The computer-program product embodied in the non-transitory computer readable medium of any of examples 14 to 16, the computer-program product comprising instructions to: filter out frequencies above a first predetermined frequency after rectification to provide rectified signal, wherein rectified signal is indicative of an envelope follower which tracks an amplitude of the audio input signal.

Example 18. The computer-program product embodied in the non-transitory computer readable medium of any of examples 14 to 17, the computer-program product comprising instructions to: filter out frequencies below a first predetermined frequency of the audio input signal prior to applying the saturation and rectification.

Example 19. The computer-program product embodied in the non-transitory computer readable medium of any of examples 14 to 18, the computer-program product comprising instructions to:
transmit the audio output signal to one or more loudspeakers for playback.

## Claims

1. An audio system comprising:
an amplifier including at least one controller and being programmed to:
receive an audio input signal;
apply saturation to at least the audio input signal by introducing non-linear distortion to provide an audio output signal; and
transmit an audio output signal to one or more loudspeakers to playback the audio out of a first loudspeaker of the one or more loudspeakers.

2. The system of claim 1, wherein the at least one controller is further programmed to add harmonics to the audio input signal prior to applying saturation.

3. The system of claim 1, wherein the at least one controller is further programmed to rectify the audio input signal prior to applying saturation to the audio input signal.

4. The system of claim 3 wherein the at least one controller includes a first filter that is programmed to filter out frequencies on the audio input signal that are above a first predetermined frequency after rectifying the audio input signal to provide an intermediate audio signal.

5. The system of claim 4, wherein the intermediate audio signal is indicative of an envelope follower which tracks an amplitude of the audio input signal.

6. The system of claim 5, wherein the at one controller is further programmed to multiply the intermediate audio signal by a signal that includes the saturation to provide the audio output signal.

7. The system of claim 1, wherein the amplifier defines a first path in which the audio input signal traverses at least one of a first filter, a second filter, a rectifier, a third filter, a harmonic pre-gain block, and a saturation circuit to provide a saturated audio signal.

8. The system of claim 7, wherein the amplifier defines a second path in which the audio input signal is mixed with the saturated audio signal from the first path to provide the audio output signal prior to the audio output signal being played out by the one or more loudspeakers.

9. The system of claim 1, wherein the amplifier is positioned in a vehicle.

10. A method comprising:
receiving an audio input signal;
applying saturation to at least the audio input signal to generate a saturated signal and provide an audio output signal; and
playing back the audio output signal via one or more loudspeakers.

11. The method of claim 10, further comprising:
adding harmonics to the audio input signal prior to applying saturation.

12. The method of claim 10, further comprising:
rectifying the audio input signal to generate a rectified signal;
combining the rectified signal with saturated signal to generate a combined signal; and
mixing the combined signal with the audio input signal to generate the audio output signal.

13. The method of claim 12 further comprising:
filtering out frequencies above a first predetermined frequency after rectification to provide rectified signal, wherein rectified signal is indicative of an envelope follower which tracks an amplitude of the audio input signal.
